# EUROPEAN PATENT APPLICATION

(11) **EP 2 682 992 A1**
(43) Date of publication of application: **08.01.2014**
(21) Application number: 12752035.1
(22) Date of filing: 24.02.2012
(51) Int. Cl.: H01L 33/20, H01L 33/22

(54) **LIGHT-EMITTING DIODE CHIP**

(30) Priority: 03.03.2011 KR 20110018923
(71) Applicant: Seoul Opto Device Co., Ltd., Gyeonggi-do 425-851 (KR)
(72) Inventor: LEE, Kyu Ho, Ansan-si Gyeonggi-do 425-851 (KR); SUH, Dae Woong, Ansan-si Gyeonggi-do 425-851 (KR); SEO, Won Cheol, Ansan-si Gyeonggi-do 425-851 (KR); KIM, Chang Hoon, Ansan-si Gyeonggi-do 425-851 (KR); LEE, Sung Hyun, Ansan-si Gyeonggi-do 425-851 (KR); IN, Chi Hyun, Ansan-si Gyeonggi-do 425-851 (KR)
(74) Representative: Stolmár & Partner
(86) International application number: PCT/KR2012/001435
(87) International publication number: WO 2012/118303

(57) **Abstract**

The present invention relates to a light emitting diode chip. According to the present invention, a light emitting diode chip including a substrate having a thickness exceeding 120 µm and a light emitting diode disposed on one surface of the substrate is provided.

## Description

### [Technical Field]

The present invention relates to a light emitting diode chip.

### [Background Art]

Light emitting diodes are basically PN junction diodes formed at a junction between p-type and n-type semiconductors.

When voltage is applied to p-type and n-type semiconductors of a light emitting diode, holes move from the p-type semiconductor toward the n-type semiconductor and electrons move from the n-type semiconductor toward the p-type semiconductor, such that both electrons and holes move into the PN junction.

Electrons moving into the PN junction are combined with the holes while dropping from a conduction band to a valence band. Here, an energy corresponding to a height difference between the conduction band and the valence band, that is, an energy difference, is emitted in the form of light.

Generally, light emitting diode chips are prepared through several processes. First, plural semiconductor layers including an n-type semiconductor layer, an active layer and a p-type semiconductor layer are formed on one surface of a substrate. Then, a plurality of light emitting diodes is formed on the one surface of the substrate by partial mesa etching of the plural semiconductor layers to expose the n-type semiconductor layer while performing separation etching to separate the plural semiconductor layers for formation of the plural light emitting diodes, and a plurality of light emitting diode chips is formed by dividing the substrate.

Here, a typical substrate of the light emitting diode chips has a thickness of 120 µm for dividing of the substrate and mounting on a sub-mount in flip chip form.

### [Disclosure]

### [Technical Problem]

It is an aspect of the present invention to provide a light emitting diode chip that includes a thick substrate to exhibit high light extraction efficiency.

### [Technical Solution]

In accordance with one aspect of the invention, a light emitting diode chip comprises a substrate having a thickness exceeding 120 µm, and a light emitting diode disposed on one surface of the substrate.

The substrate may comprise a plurality of protrusions on a side surface thereof.

The substrate may comprise concavo-convex structures on the other surface thereof.

The substrate may have a thickness from 200 µm to 400 µm.

The substrate may be a transparent substrate.

Light emitted from the light emitting diode may be at least partially extracted through the substrate.

The substrate may be a sapphire substrate.

### [Advantageous Effects]

Embodiments of the invention provide a light emitting diode chip that includes a thick substrate, thereby exhibiting high light extraction efficiency.

### [Description of Drawings]

Fig. 1 is a sectional view of a light emitting diode chip according to one embodiment of the present invention;
Fig. 2 is a sectional view of a light emitting diode assembly including a light emitting diode chip according to one embodiment of the present invention;
Figs 3 and 4 are sectional views showing a method for manufacturing a light emitting diode assembly according to one embodiment of the present invention; and
Fig. 5 is a graph depicting light emitting power (Po) depending on substrate thickness of a light emitting diode assembly according to one embodiment of the present invention.

### [Best Mode]

Hereinafter, embodiments of the present invention will be described in detail with reference to the accompanying drawings.

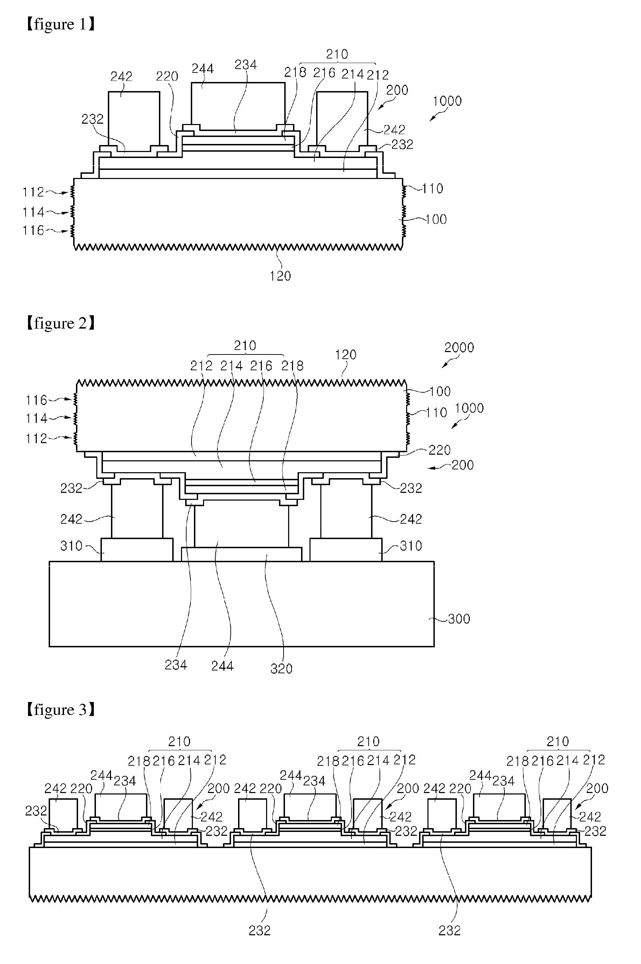

Fig. 1 is a sectional view of a light emitting diode chip according to one embodiment of the present invention.

Referring to Fig. 1, a light emitting diode chip 1000 according to one embodiment may comprise a substrate 100 and a light emitting diode 200.

The substrate 100 may be a growth substrate. In addition, the substrate 100 may be a transparent substrate allowing light emitted from the light emitting diode 200 to be at least partially transmitted and extracted outside. The transparent substrate may be a sapphire substrate.

The substrate 100 has a greater thickness than typical substrates for light emitting diode chips.

The substrate 100 may have a greater width than the light emitting diode 200. That is, as shown in Fig. 1, the substrate 100 may have a large enough size for the light emitting diode 200 to be disposed within a certain region on one surface of the substrate 100.

Since the substrate 100 has a greater width than the light emitting diode 200, light emitted from the light emitting diode 200 can be easily extracted from a side surface of the substrate 100, thereby improving luminous efficacy.

According to embodiments, since the substrate 100 is divided by various methods for dividing a thicker substrate than a typical substrate, such as internal processing laser beam processing, blasting, and the like, the substrate 100 may have a greater thickness than a typical substrate of light emitting diode chips. The light emitting diode chip 1000 according to one embodiment may comprise the substrate 100 having a greater thickness than the typical substrate of the light emitting diode chips having a thickness of 120 µm. That is, the substrate 100 may have a thickness exceeding 120 µm. Preferably, the substrate 100 has a thickness of 200 µm to 400 µm.

The substrate 100 may comprise a plurality of protrusions 110 on the side surface thereof. The protrusions 110 may be formed during formation of the light emitting diode chips 1000. Preferably, the protrusions 110 may be formed during division of the substrate 100. In addition, the protrusions 110 may be formed by processing the side surface of the substrate 100 of each of the light emitting diode chips 1000 after the substrate 100 is divided.

The protrusions 110 may be disposed at regular intervals or irregularly on the side surface of the substrate 100. In addition, the protrusions 110 may have the same shape or different shapes. Further, the protrusions 110 may have the same size or different sizes.

Here, as shown in Fig. 1, the protrusions 110 may be formed during division of the substrate 100. Preferably, the protrusions 110 may be formed by dividing the substrate 100 after irradiation with an internal processing laser beam three times at different depths, that is, after the internal processing laser beam is irradiated along three irradiation lines in a depth direction of the substrate 100. That is, the protrusions 110 may be formed on three protrusion regions 112, 114, 116 corresponding to the three irradiation lines formed by irradiating the substrate 100 with the internal processing laser beam three times at different depths in order to divide the substrate 100. Namely, the protrusions 110 may be formed by irradiating the substrate 100 with the internal processing laser beam.

Here, other regions excluding the protrusion regions 112, 114, 116 from the side surface of the substrate 100, that is, regions to which the internal processing laser beam is not irradiated may be flatter than the protrusion regions 112, 114, 116. That is, the other regions excluding the protrusion regions may have lower roughness than the protrusion regions 112, 114, 116.

The light emitting diode 200 may be disposed on one surface of the substrate 100.

The light emitting diode 200 may be disposed on the one surface of the substrate 100, and may comprise a semiconductor structure layer 210, a passivation layer 220, pads 232, 234, and bumps 242, 244. Here, if the light emitting diode chip 1000 is not formed in flip chip form, the bumps 242, 244 and the like may be omitted.

The semiconductor structure layer 210 may comprise a buffer layer 212, a first type semiconductor layer 214, an active layer 216, and a second type semiconductor layer 218. The buffer layer 212 may be omitted.

The buffer layer 212 may be disposed on the one surface of the substrate 110. The buffer layer 212 may be disposed to mitigate lattice mismatch between the substrate 100 and the first type semiconductor layer 214. In addition, the buffer layer 212 may be formed as a single layer or multiple layers, and when formed as multiple layers, the buffer layer 212 may comprise low temperature buffer layers and high temperature buffer layers.

The first type semiconductor layer 214 may be disposed on the buffer layer 212, and partially exposed, as shown in Fig. 1. The first type semiconductor layer 214 may be partially exposed by partial mesa etching of the active layer 216 and the second type semiconductor layer 218. The first type semiconductor layer 214 may also be partially etched during mesa etching.

The first type semiconductor layer 214 may be formed of an (Al, In, Ga)N-based group-III nitride semiconductor doped with a first type impurity, for example, an n-type impurity, and may be formed as a single layer or multiple layers. For example, the first type semiconductor layer 214 may comprise a superlattice layer.

The active layer 216 may be disposed on the first type semiconductor layer 214, and may be formed as a single layer or multiple layers. In addition, the active layer 216 may be formed in a single quantum well structure including a single well layer (not shown), or in a multi-quantum well structure in which well layers (not shown) and barrier layers (not shown) are alternately stacked. Here, the well layer (not shown) and/or the barrier layer (not shown) may have a superlattice structure.

The second type semiconductor layer 218 may be disposed on the active layer 216. In addition, the second type semiconductor layer 218 may be formed of an (Al, In, Ga)N-based group-III nitride semiconductor doped with a second type impurity, for example, a p-type impurity, and may be formed as a single layer or multiple layers. For example, the second type semiconductor layer 218 may comprise a superlattice layer.

In addition, the semiconductor structure layer 210 may comprise an electron blocking layer (not shown) between the active layer 216 and the second type semiconductor layer 218. The electron blocking layer (not shown) may be disposed to improve recombination efficiency of electrons and holes, and may be formed of a material having a relatively wide band gap. The electron blocking layer (not shown) may be formed of an (Al, In, Ga)N-based group-III nitride semiconductor, for example, may comprise AlGaN.

The passivation layer 220 may be disposed on the substrate 100 that semiconductor structure layer 210 is disposed thereon. The passivation layer 220 serves to protect the semiconductor structure layer 210 thereunder from external environment, and may be formed of an insulating film comprising a silicon oxide film or a silicon nitride film.

The passivation layer 220 may comprise openings through which surfaces of the first semiconductor layer 214 and second type semiconductor layer 218 exposed by mesa etching are partially exposed.

The pads 232, 234 may comprise first and second pads 232, 234. The first pad 232 may contact the first type semiconductor layer 214 exposed through the openings, and the second pad 234 may contact the second type semiconductor layer 218 exposed through the openings.

Here, although not shown in the drawings, the second type semiconductor layer 218 may comprise a high concentration semiconductor layer (not shown), an upper portion of which is doped with a second type impurity in a high concentration, and a contact electrode (not shown) for ohmic contact may be interposed between the second type semiconductor layer 218 and the second pad 234. The pads 232, 234 may comprise a material such as Ni, Cr, Ti, Al, Ag, Au, and the like. The contact electrode (not shown) may comprise TCO (Transparent Conductive Oxide) such as ITO, ZnO, IZO and the like, and contact materials such as Ni/Au, and the like.

The bumps 242, 244 may comprise first and second bumps 242, 244. The first bump 242 may be disposed on the first pad 232, and the second bump 244 may be disposed on the second pad 234. The bumps 242, 244 support the substrate 100 when the substrate 100 that the semiconductor structure layer 210 is disposed thereon is mounted on a sub-mount (not shown), and may comprise Au.

The substrate 100 may have concavo-convex structures 120 on the other surface thereof. The concavo-convex structures 120 serve to improve light extraction efficiency of light extracted in the other surface direction. When light emitted from the semiconductor structure layer 210, precisely speaking, from the active layer 216 of the semiconductor structure layer 210 is extracted through the other surface direction, the concavo-convex structures 120 reduce total reflection on the other surface of the substrate 100, and thus improve a probability that the light is extracted from the other surface of the substrate 100, thereby improving light extraction efficiency.

The concavo-convex structures 120 may be formed in patterns, such as moth eye patterns, and the like, on the other surface of the substrate 100 in advance, may be formed during the process of dividing the substrate 100, or may be formed using a blasting or laser beam processing method after the process of dividing the substrate. The concavo-convex structures 120 may have a height of 100 nm to 1 µm. Here, the concavo-convex structures 120 may have other shapes depending on a wavelength range of light emitted from the light emitting diode chips 1000.

As such, the substrate 100 of the light emitting diode chip 1000 has a thickness exceeding 120 µm, so that the light emitting diode chip 1000 according to the embodiment exhibits higher luminous efficacy than typical light emitting diode chips. In addition, the substrate 100 has the protrusions 110 formed on the side surface thereof to improve light extraction efficiency of light traveling toward the side surface of the substrate 100, so that the light emitting diode chip 1000 according to the embodiment exhibits higher luminous efficacy than typical light emitting diode chips.

Fig. 2 is a sectional view of a light emitting diode assembly comprising a light emitting diode chip according to one embodiment of the present invention.

Referring to Fig. 2, a light emitting diode assembly 2000 according to one embodiment may comprise the light emitting diode chip 1000 as described with reference to Fig. 1 and a sub-mount 300.

Here, since the light emitting diode chip 1000 has been described in detail with reference to Fig. 1, descriptions thereof will be omitted.

The light emitting diode assembly 2000 may be prepared in a form in which the light emitting diode chip 1000 is mounted on the sub-mount 300. That is, the sub-mount 300 comprises first and second electrodes 310, 320 on one surface thereof, and the light emitting diode chip 1000 is mounted on the sub-mount 300 such that the first and second bumps 242, 244 of the light emitting diode chip 1000 are respectively connected to the first and second electrodes 310, 320, thereby preparing the light emitting diode assembly 2000.

Thus, the light emitting diode assembly 2000 according to the embodiment may have the substrate 100 having a greater thickness than 120 µm, that is, a thickness exceeding 120 µm at a side from which light emitted from the light emitting diode 200 is extracted. Preferably, the substrate 100 has a thickness from 200 µm to 400 µm.

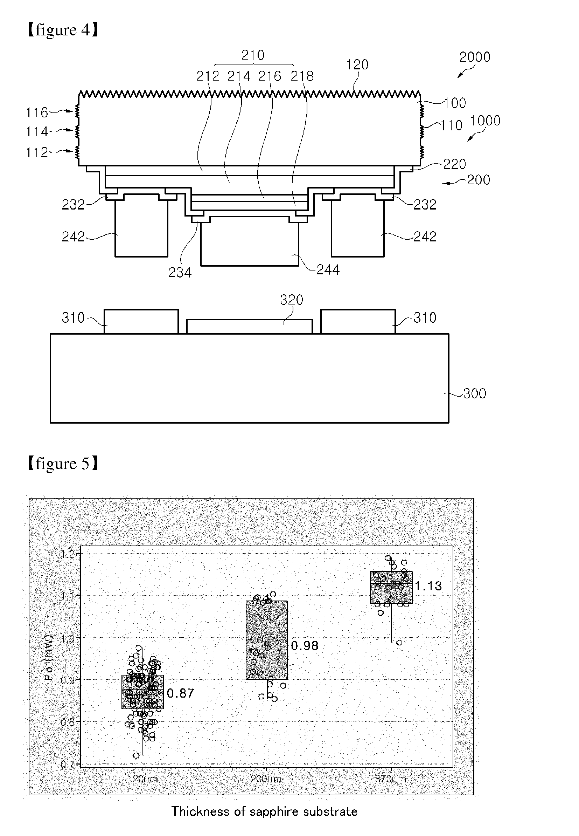

Figs 3 and 4 are sectional views showing a method for manufacturing a light emitting diode assembly according to one embodiment of the present invention.

Referring to Fig. 3, first, a method for manufacturing a light emitting diode assembly according to one embodiment may start with the preparation of a substrate 100. A plurality of semiconductor layers comprising a buffer layer 212, a first type semiconductor layer 214, an active layer 216 and a second type semiconductor layer 218 is formed in order. Here, the substrate 100 may be a sapphire substrate, and may have a thickness exceeding 120 µm. The substrate 100 may be a substrate having pre-formed concavo-convex structures 120 on the other surface thereof. In addition, although not shown in the drawings, the substrate 100 may be a substrate having no pre-formed concavo-convex structures 120 on the other surface thereof.

Here, the plurality of semiconductor layers, such as the buffer layer 212, the first type semiconductor layer 214, the active layer 216, the second type semiconductor layer 218, and the like, may be formed using methods for forming semiconductor layers known in the art, such as MOCVD, molecular beam growth, epitaxial growth, and the like.

Next, in order to form a plurality of light emitting diodes 200, the buffer layer 212, the first type semiconductor layer 214, the active layer 216 and the second type semiconductor layer 218 are separated by etching.

Next, mesa etching is performed such that the separated first type semiconductor layer 214 is partially exposed, thereby forming a plurality of semiconductor structure layers 210 including the buffer layer 212, the first type semiconductor layer 214, the active layer 216 and the second type semiconductor layer 218.

Next, after a passivation forming layer is formed on the overall surface of the substrate 100, a passivation layer 220 is formed by partial etching of the passivation forming layer to form openings through which the surfaces of the first and second type semiconductor layers 214, 218 are partially exposed.

Next, pads 232, 234 may be formed on the substrate 100. Here, the pads 232, 234 may comprise a first pad 232 contacting the first type semiconductor layer 214 through the openings through which the surface of the first type semiconductor layer is partially exposed, and a second pad 234 contacting the second type semiconductor layer 218 through the openings through which the surface of the second type semiconductor layer is partially exposed.

Here, although not shown in the drawings, before formation of the pads 232, 234, a contact electrode (not shown) contacting the second type semiconductor layer 218 through the openings is formed first, and then, the second pad 234 may be formed on the contact electrode (not shown).

Next, bumps 242, 244 including first and second bumps 242, 244 are formed on the first and second pads 232, 234, thereby forming the plurality of light emitting diodes 200 separated from each other on one surface of the substrate 100.

Next, in order to divide the light emitting diodes 200 from each other, a process of dividing the substrate 100 is performed. Here, a typical process of dividing light emitting diodes is performed after the other surface of the substrate is polished such that the substrate has a final thickness of 100 µm to 120 µm. As described above, when the substrate has a great thickness in the typical dividing process, failure, such as chipping, double chip, and the like, occurs during division of the substrate, and when the substrate has too thin a thickness, cracking or breakage due to ultrasonic waves, compression, and the like are generated in a subsequent process of mounting the light emitting diode chips on a sub-mount. Thus, the substrate is typically polished to a thickness from 100 µm to 120 µm.

However, unlike such a typical process, in the method for manufacturing a light emitting diode assembly according to the embodiment, since the substrate 100 is divided using methods which is possible to divide even the thick substrate 100, such as a laser beam processing method, blasting method, and the like, it is possible to omit a process of polishing a rear surface of the substrate 100.

During or after the process of dividing the substrate, a process of forming a plurality of protrusions 110 on the side surface of the substrate 100 may be performed.

Here, a process of forming protrusions 110 during the dividing process may be performed using the process of dividing the substrate 100 using an internal processing laser beam. That is, the substrate 100 is divided after irradiating the substrate with the internal processing laser beam multiple times along division lines at different depths, whereby the protrusions 110 may be formed within irradiation lines of the internal processing laser beam, that is, protrusion regions 112,114,116.

In another process of forming the protrusions 110 during the dividing process, blast marks are formed on the side surface of the substrate 100 using a blasting method while the substrate 100 is divided, so that the protrusions 110 are formed by the blast marks. Here, the blasting method may be sand blasting. Sand blasting is a process using particles such as sand, and the like, and the process of dividing the substrate 100 and the process of forming the protrusions 110 may be simultaneously performed using, for example, particles having different particle sizes when dividing the substrate 100 and when forming the sand blast marks.

When the processes of dividing the substrate 100 and forming the protrusions 110 are separately performed, the protrusions 110 may be formed on the side surface of the substrate 100 by various methods after dividing the substrate 100. That is, the protrusions 110 may be formed by surface treatment of the side surface of the separated substrate 100 using the blasting method, or may be formed by etching the side surface of the substrate 100.

Although the other surface of the substrate 100 need not be polished, polishing may be performed such that the substrate 100 has a thickness exceeding 120 µm instead of a thickness from 100 µm to 120 µm as in a typical process.

Here, the substrate 100 has no pre-formed concavo-convex structures 120 on the other surface thereof, and the concavo-convex structures 120 may be formed during or after the process of dividing the substrate 100. The concavo-convex structures 120 may be formed during the process of dividing the substrate 100, while exposing the other surface of the substrate 100 when the substrate is divided using the blasting method. In addition, during or after the dividing process, the concavo-convex structures 120 may be formed by laser beam irradiation on the other surface of the substrate 100.

Referring to Fig. 4, independently of the preparation process of the light emitting diode chip 1000 by dividing the substrate, a sub-mount 300 having first and second electrodes 310, 320 on one surface thereof is prepared.

Next, after the sub-mount 300 is aligned with the light emitting diode chip 1000 such that the first and second bumps 242, 244 of the light emitting diode chip 1000 respectively correspond to the first and second electrodes 310, 320 of the sub mount 300, the light emitting diode assembly 2000 may be formed by flip bonding the electrodes 310, 320 to the bumps 242, 244, as shown in Fig. 2. Here, flip bonding may be performed using a thermal ultrasonic method or thermal compression method.

Fig. 5 is a graph depicting light emitting power (Po) depending on substrate thickness of a light emitting diode assembly according to one embodiment of the present invention.

Referring to Fig. 5, the light emitting diode assembly 2000 according to one embodiment as described with reference to Fig. 2 is prepared, and light emitting power (Po (mW)) of the light emitting diode assembly 2000 was measured by applying a current of 20 mA thereto. In addition, after packaging the light emitting diode assembly 2000, light emitting power was measured under the same conditions.

When a current of 20 mA was applied to the light emitting diode assembly 2000, the light emitting power was 1.25 mW in the substrate 100 of the light emitting diode assembly 2000 having a thickness of 120 µm as in a typical substrate, 1.30 mW in the substrate having a thickness of 200 µm, and 1.57 mW in the substrate having a thickness of 370 µm. Thus, it could be seen that, when the substrate had thicknesses of 200 µm and 370 µm, greater than the typical 120 µm thick substrate, the light emitting power was increased by about 3.4% and 25.1%, respectively.

In addition, when a current of 20 mA was applied to a packaged light emitting diode assembly 2000, the light emitting power was 0.87 mW in the substrate 100 of the packaged light emitting diode assembly 2000 having a thickness of 120 µm as in the typical substrates, 0.98 mW in the substrate having a thickness of 200 µm, and 1.13 mW in the substrate having a thickness of 370 µm. Thus, it could be seen that, when the substrate had thicknesses of 200 µm and 370 µm, greater than the typical 120 µm thick substrate, the light emitting power was increased by about 13.2% and 29.5%, respectively.

Therefore, as described above, when the light emitting diode assembly 2000 according to the embodiment and the packaged light emitting diode assembly comprise the substrate having a thickness exceeding 120 µm, it could be confirmed that the light emitting power thereof was further increased.

Although the present invention has been described with reference to some embodiments, it should be understood that the foregoing embodiments are not to be in any way construed as limiting the present invention, and that various modifications, changes, alterations, and equivalent embodiments can be made by those skilled in the art without departing from the spirit and scope of the invention.

## Claims

1. A light emitting diode chip comprising:
a substrate having a thickness exceeding 120 µm; and
a light emitting diode disposed on one surface of the substrate.

2. The light emitting diode chip of claim 1, wherein the substrate has a plurality of protrusions on a side surface thereof.

3. The light emitting diode chip of claim 1, wherein the substrate has concavo-convex structures on the other surface thereof.

4. The light emitting diode chip of claim 1, wherein the substrate has a thickness from 200 µm to 400 µm.

5. The light emitting diode chip of claim 1, wherein the substrate is a transparent substrate.

6. The light emitting diode chip of claim 5, wherein light emitted from the light emitting diode is at least partially extracted through the substrate.

7. The light emitting diode chip of claim 6, wherein the substrate is a sapphire substrate.
